# EUROPEAN PATENT APPLICATION

(11) **EP 4 752 997 A1**
(43) Date of publication of application: **03.06.2026**
(21) Application number: 25215632.8
(22) Date of filing: 13.11.2025
(51) Int. Cl.: H01M 10/04, H01M 50/204

(54) **BATTERY PACK ASSEMBLY UNIT**

(30) Priority: 27.11.2024 KR 20240171870
(71) Applicant: SAMSUNG SDI CO., LTD., Yongin-si, Gyeonggi-do 17084 (KR)
(72) Inventor: CHO, Dong Bum, 16678 Suwon-si (KR)
(74) Representative: Marks & Clerk LLP

(57) **Abstract**

A battery pack assembly unit includes a pallet including a plate configured to support components of one or more battery packs, one or more support fixtures configured to constrain the components from moving, a transfer conveyor configured to transport the pallet, and a support fixture moving device disposed above the transfer conveyor and configured to change positions of the support fixtures based on a shape and a size of each of the components.

## Description

### FIELD

The present disclosure relates to a battery pack assembly unit.

### BACKGROUND

In general, unlike a primary battery that cannot be recharged, a secondary battery is a battery that can be recharged and discharged. A low-capacity secondary battery may be used for portable small-sized electronic devices, such as smartphones, feature phones, notebook computers, digital cameras, and camcorders, and a high-capacity secondary battery is widely used as a power source for driving a motor and a power storage battery in hybrid vehicles or electric vehicles. The secondary battery includes an electrode assembly including a positive electrode and a negative electrode, a case accommodating the electrode assembly, an electrode terminal connected to the electrode assembly, and the like.

The secondary battery may be used as a battery pack formed of a plurality of unit battery cells connected in series and/or parallel to provide high energy density. The battery pack may be formed by connecting electrode terminals of a plurality of unit batteries to one another to meet a required amount of power and to implement a high-power secondary battery of, for example, an electric vehicle.

The battery pack may be manufactured through a plurality of assembly and inspection processes, and the assembly and inspection of the battery pack may be performed while transporting a pallet along a production line to each process position. There has been an increasing demand for the production of battery packs for a wider range of models, but there is a problem in that battery pack production lines are limited.

The herein-described information disclosed in the technology that forms the background of the present disclosure is only intended to improve understanding of the background of the present disclosure, and thus may include information that does not constitute the related art.

### SUMMARY

The present disclosure is directed to providing a battery pack assembly unit capable of manufacturing battery packs of different models on a single battery pack production line.

These and other aspects and features of the present disclosure will be described in or will be apparent from the following description of some embodiments of the present disclosure.

According to an aspect of the present disclosure, there is provided a battery pack assembly unit including a pallet including a plate configured to support components of one or more battery packs, and one or more support fixtures configured to constrain the components from moving, a transfer conveyor configured to transport the pallet, and a support fixture moving device disposed above the transfer conveyor and configured to change positions of the one or more support fixtures based on a shape and a size of each of the components.

Each of the battery packs may include a housing seated on the pallet, and one or more battery cells accommodated in the housing, and the component may include the housing.

The plate may include a plate body loaded on the transfer conveyor, a plurality of installation bases which are installed on an upper surface of the plate body, and to which the one or more support fixtures are detachably coupled.

Each of the installation bases may include an installation base body disposed on the upper surface of the plate body, a fastening groove formed in the installation base body and having a female screw structure that allows the support fixture to be screwed, and fixing members disposed on both sides of the fastening groove and configured to fix the installation base body to the plate body.

The pallet may include a first region on which a first component included in a first battery pack is seated, a second region on which a second component included in a second battery pack is seated, and a third region shared by a portion of the first region and a portion of the second region, and the one or more support fixtures may include one or more first support fixtures disposed in the third region and configured to support the first component, and one or more second support fixtures configured to support the second component.

The installation bases may include one or more first installation bases to which the one or more first support fixtures are detachably fastened, and which are positioned in the first region, at least one first installation base being positioned in the third region, one or more second installation bases to which the one or more second support fixtures are detachably fastened, and which are positioned in the second region, and one or more third installation bases to which the one or more first support fixtures are detachably fastened, and which are positioned outside the second region, and the one or more first support fixtures are fastened to the first installation bases when the first component is assembled, and are unfastened from the first installation bases and then fastened to the third installation bases by the support fixture moving device when the second component is assembled.

The first component may have a width greater than half a width of the plate and one first component may be placed on the pallet, the second component may have a width less than half the width of the plate and a plurality of second components may be placed on the pallet, the one or more first support fixtures may be disposed to correspond to edges of the first component, and the one or more second support fixtures may be disposed to correspond to edges of the second component.

One or more of the second support fixtures may be disposed in the third region, and each of the second support fixtures disposed in the third region may have a shorter length than each of the first support fixtures to prevent interference with the first component when the first component is in contact with the first support fixtures.

The installation bases may include a first group formed by arranging the plurality of second installation bases at a first position along one of the edges of at least one of the first component and the second component, and a second group formed by arranging the plurality of second installation bases at a second position, which is spaced apart from the first position, along one of the edges of at least one of the first component and the second component, and each second support fixture may be fastened to one of the plurality of second installation bases, which form the first group when the second component is assembled, and moved to another one of the plurality of second installation bases, which form the first group, and fastened thereto by the support fixture moving device when a third component included in a third battery pack is assembled.

Each of the support fixtures may include a support bar disposed to protrude upwardly from the plate, a fastening portion formed at a lower portion of the support bar, having a male screw structure, and detachably screwed onto the plate, and a holding portion formed at an upper part of the support bar and configured to engage with the support fixture moving device.

The holding portion may include a rotation holding portion having a cross-sectional shape other than a circular cross-sectional shape and configured to engage with a fastening device of the support fixture moving device, a grip holding portion disposed below the rotation holding portion, formed to be recessed along a circumference of the support fixture, and held by a gripper device of the support fixture moving device, and a locking step which is formed between the rotation holding portion and the grip holding portion, and on which the gripper device of the support fixture moving device is caught.

The support fixture moving device may include a fastening device configured to fasten or unfasten the support fixtures to or from the plate, a gripper device configured to clamp or unclamp the support fixtures, a moving device configured to move the support fixture gripped by the gripper device to a first set position or a second set position on the pallet, and a control device configured to control an operation of each of the fastening device, the gripper device, and the moving device.

The fastening device may include a first support installed on the moving device, a first actuator fixed to the first support and configured to output a rotational force, and a socket connected to the first actuator and configured to engage with the support fixture when the fastening device descends.

The gripper device may include a second support installed on the moving device, a second actuator fixed to the second support and configured to output a hydraulic or pneumatic pressure, a guide block installed on the second support, a first gripper installed on the guide block, and a second gripper disposed on the guide block to face the first gripper, with a distance from the first gripper variable by an operation of the second actuator.

The first gripper may include a block connection portion installed on the guide block to be reciprocally movable in a direction toward or away from the second gripper, an extension portion extending downwardly from the block connection portion to a lower side of the socket, and a gripping finger connected to the extension portion, positioned below the socket to face the support fixture, and having an arcuate shape, which corresponds to a circumference of the support fixture, on one surface facing the support fixture.

The support fixture moving device may further include a detection device configured to detect a position of the support fixture mounted on the pallet, and the control device may control the operation of each of the fastening device, the gripper device, and the moving device based on detection information from the detection device.

The moving device may include a guide bar formed to extend in a first direction, a first moving body formed to extend in a second direction and installed on the guide bar to be movable in the first direction, a second moving body formed to extend in a third direction and installed on the first moving body to be movable in the second direction, and a third moving body which is installed on the second moving body to be movable up and down in the third direction, and on which the fastening device, the gripper device, and the detection device are installed.

The third moving body may include an elevating body installed on the second moving body to be movable up and down in the third direction, a first rail which is formed on the elevating body, and on which the detection device is installed to be movable up and down, and a second rail which is disposed parallel to the first rail, and on which the fastening device and the gripper device are installed to be movable up and down.

The control device, upon detecting through the detection device that the support fixture is positioned at the first set position, may control the fastening device, the gripper device, and the moving device to unfasten the support fixture at the first set position, move the support fixture to the second set position, and fasten the support fixture at the second set position.

The control device may perform control to sequentially perform a first moving operation of positioning the detection device at the first set position, a first descending operation of lowering the detection device along the first rail to position the detection device below the gripper device, and lowering the third moving body while the detection device remains positioned below the gripper device, a support fixture detection operation of detecting the support fixture using the detection device, a first ascending operation of raising and returning the detection device along the first rail, a device exchange operation of moving the fastening device and the gripper device to position the fastening device and the gripper device at the first set position, a second descending operation of lowering the fastening device and the gripper device along the second rail to position the fastening device and the gripper device below the detection device, and lowering the third moving body while the fastening device and the gripper device remain positioned below the detection device, an unfastening operation of applying a rotational force to the support fixture using the fastening device to unfasten the support fixture from the plate, a clamping operation of clamping the support fixture using the gripper device, a second ascending operation of raising the third moving body and moving the gripper device upwardly along the second rail, a second moving operation of moving the support fixture to the second set position, a third descending operation of lowering the fastening device and the gripper device along the second rail to position the fastening device and the gripper device below the detection device, and lowering the third moving body while the fastening device and the gripper device remain positioned below the detection device, an unclamping operation of unclamping the support fixture, and a fastening operation of applying a rotational force to the support fixture using the fastening device to fasten the support fixture to the plate.

At least some of the above and other features of the invention are set out in the claims.

### BRIEF DESCRIPTION OF THE DRAWINGS

The drawings attached to this specification illustrate some embodiments of the present disclosure, and further describe aspects and features of the present disclosure together with the detailed description of the present disclosure. However, the present disclosure should not be construed as being limited to the drawings:
FIG. 1 is a perspective view schematically illustrating a battery pack assembly unit according to embodiments of the present disclosure;
FIG. 2 is a main part exploded perspective view schematically illustrating an example of a battery pack to be assembled by the battery pack assembly unit according to embodiments of the present disclosure;
FIG. 3 is a perspective view schematically illustrating a pallet according to embodiments of the present disclosure;
FIG. 4 is a main part exploded perspective view schematically illustrating a support fixture and an installation base according to embodiments of the present disclosure;
FIG. 5 is a plan view schematically illustrating the pallet according to embodiments of the present disclosure;
FIG. 6 is a conceptual diagram illustrating a first region of the pallet according to embodiments of the present disclosure;
FIG. 7 is a conceptual diagram illustrating a second region of the pallet according to embodiments of the present disclosure;
FIG. 8 is a conceptual diagram illustrating the first region, the second region, and a third region of the pallet according to embodiments of the present disclosure;
FIG. 9 is a perspective view illustrating a state in which a first component is seated on the first region of the pallet according to embodiments of the present disclosure;
FIG. 10 is a perspective view schematically illustrating another example of the plate according to embodiments of the present disclosure;
FIG. 11 is a perspective view illustrating a state in which a second component is seated on the second region of the pallet according to embodiments of the present disclosure;
FIG. 12 is a perspective view schematically illustrating still another example of the plate according to embodiments of the present disclosure;
FIG. 13 is a perspective view illustrating a state in which a third component is seated on the second region of the pallet according to embodiments of the present disclosure;
FIG. 14 is a main part perspective view schematically illustrating a support fixture moving device according to embodiments of the present disclosure;
FIG. 15 is a flowchart illustrating a process of moving the support fixture from a first set position to a second set position using the support fixture moving device according to embodiments of the present disclosure; and
FIGS. 16 to 21 are conceptual diagrams illustrating the process of moving the support fixture from the first set position to the second set position using the support fixture moving device according to embodiments of the present disclosure.

### DETAILED DESCRIPTION

Herein, some embodiments of the present disclosure will be described, in further detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of " 1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural. When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to one another, or one or more intervening elements may be present therebetween, through which the element may be "coupled," "linked," or "connected" to another element. In addition, when a part is referred to as being "electrically coupled" to another part, the part may be directly electrically connected to another part or one or more intervening parts may be present therebetween such that the part and the another part are indirectly electrically connected to one another.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

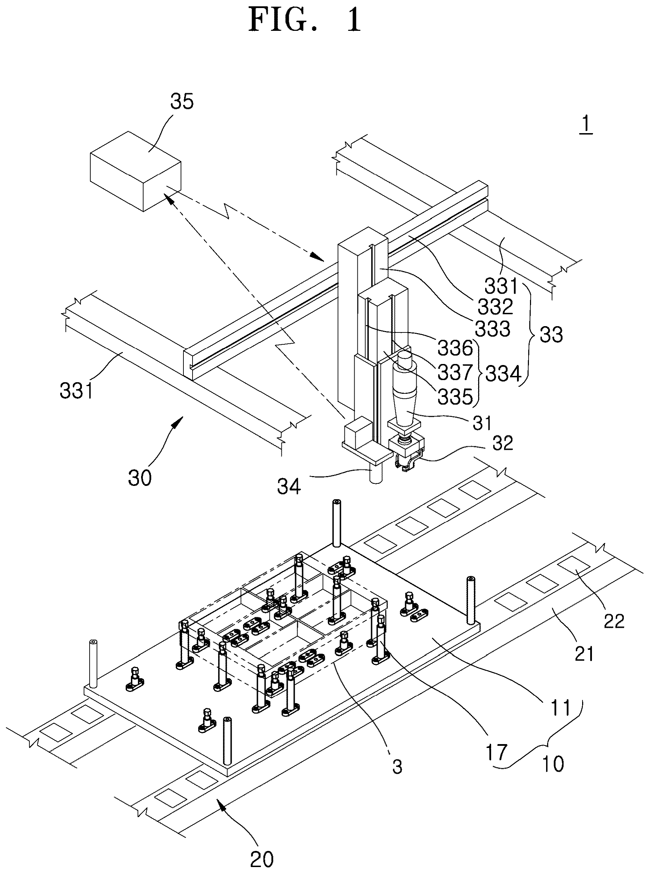

FIG. 1 is a perspective view schematically illustrating a battery pack assembly unit 1 according to embodiments of the present disclosure.

Referring to FIG. 1, the battery pack assembly unit 1 according to embodiments of the present disclosure includes a pallet 10, a transfer conveyor 20, and a support fixture moving device 30.

The pallet 10 provides a base on which components 3 of a battery pack 2 to be assembled can be loaded and mounted. The pallet 10 includes a plate 11 that supports the components 3 of the battery pack 2 from herein, and one or more support fixtures 17 that constrain the movement of the components 3.

The transfer conveyor 20 transports the pallet 10. The transfer conveyor 20 may have a conveyor structure. The pallet 10 may be seated and loaded on the transfer conveyor 20 and transported in an extending direction of the transfer conveyor 20 (e.g., forward). The plate 11 of the pallet 10 may have a shape that can be seated on the transfer conveyor 20.

For example, the transfer conveyor 20 may have a structure in which a pair of transfer rails 21 extend in parallel, and rotating rollers 22, which are rotated in conjunction with a motor (not shown), may be arranged to be exposed upwardly on upper portions of the transfer rails 21. The plate 11 can be transported forward along the transfer conveyor 20 in conjunction with the rotation of the rotating rollers 22, while both side portions of the plate 11 are seated on the transfer rails 21 of the transfer conveyor 20.

The support fixture moving device 30 is disposed above the transfer conveyor 20 and adjusts positions of the support fixtures 17 according to the shape and size of the component 3. The positions of the support fixtures 17 can be changed by the support fixture moving device 30 according to the shape and size of the component 3. By changing the positions of the support fixtures 17 as described herein, it is possible not only to load and mount the component 3 with a first shape and a first size onto the pallet 10, but also to load and mount the component 3 with a shape and a size, at least one of which is different from the first shape and size, onto the pallet 10.

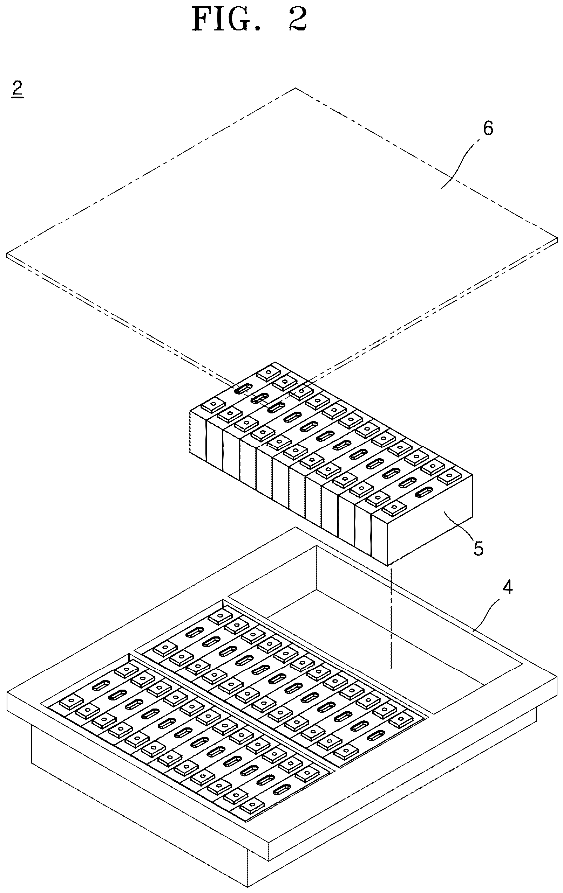

FIG. 2 is a main part exploded perspective view schematically illustrating an example of a battery pack 2 to be assembled by the battery pack assembly unit 1 according to embodiments of the present disclosure.

Referring to FIG. 2, the battery pack 2 to be assembled by the battery pack assembly unit 1 according to embodiments of the present disclosure may include a housing 4 and a battery cell 5.

The housing 4 may have a shape that can be seated on the pallet 10. The housing 4 may have the form of a container capable of accommodating one or more battery cells 5. The housing 4 may have a shape with an open top, and the battery cells 5 may be inserted and accommodated into the housing 4 through the open top of the housing 4.

The battery cells 5 may be accommodated in the housing 4. The battery cell 5 may function as a unit structure, which stores and supplies power, in the battery pack 2. Hereinafter, a case in which the battery cell 5 is a lithium-ion secondary battery having a prismatic shape will be described as an example. However, the present disclosure is not limited thereto, and the battery cell 5 may be a lithium polymer battery or a cylindrical battery.

Although a can (not referenced in the drawing) of the battery cell 5 is illustrated in the drawings as having a prismatic shape, the present disclosure is not limited thereto, and the can may be formed in various shapes such as a circular shape, a pouch shape, and the like. In addition, the battery can may be made of a metal such as aluminum, an aluminum alloy, nickel-plated steel, or a laminate film or plastic forming a pouch.

Although not shown in the drawings, the battery pack 2 may include a bus bar assembly that electrically connects a plurality of battery cells 5, an insulating material, a heat-insulating material, a cooling device, and various electrical components for controlling these devices. The housing 4 may further include a cover 6 that closes the open top after the battery cells 5 and other components 3 are accommodated and assembled therein.

The housing 4 is positioned at the lowermost part among the components 3 constituting the battery pack 2 and may have the largest size among the components 3 constituting the battery pack 2. Among the components 3 of the battery pack 2, the component 3 that is first loaded and mounted onto the pallet 10 may be the housing 4. The other components 3 of the battery pack 2 may be assembled onto the housing 4 while the housing 4 is loaded on the pallet 10.

The housing 4 may be seated on the pallet 10. The housing 4 may be seated on the plate 11 and may come into contact with a plurality of support fixtures 17, thereby being constrained from horizontal movement. The housing 4 may be in contact with an upper surface of the plate 11 or may be disposed to be raised at a predetermined height above the upper surface of the plate 11 depending on the length and arrangement of the support fixtures 17.

A groove (not shown) having a shape corresponding to at least a portion of the support fixture 17 may be formed on the housing 4 at a position corresponding to the support fixture 17. When the housing 4 is seated on the pallet 10, the support fixture 17 may be fitted into the groove of the housing 4, and the housing 4 may be constrained from moving by being engaged with the support fixture 17 fitted into the groove.

A groove (not shown) having a shape corresponding to an upper portion of the support fixture 17 may be formed on a flange portion (not referenced in the drawing), which is formed to protrude laterally from a lower portion or an edge of the housing 4. The groove may be formed to be recessed upwardly on a bottom surface of the housing 4 or on a bottom surface of the flange portion, which faces the pallet 10. When the upper portion of the support fixture 17 has a polygonal cross-sectional shape, the groove may have a corresponding polygonal cross-sectional shape. When the upper portion of the support fixture 17 has a stepped shape or an inclined surface that narrows in width upwardly, the groove may have a corresponding stepped or inclined cross-sectional shape.

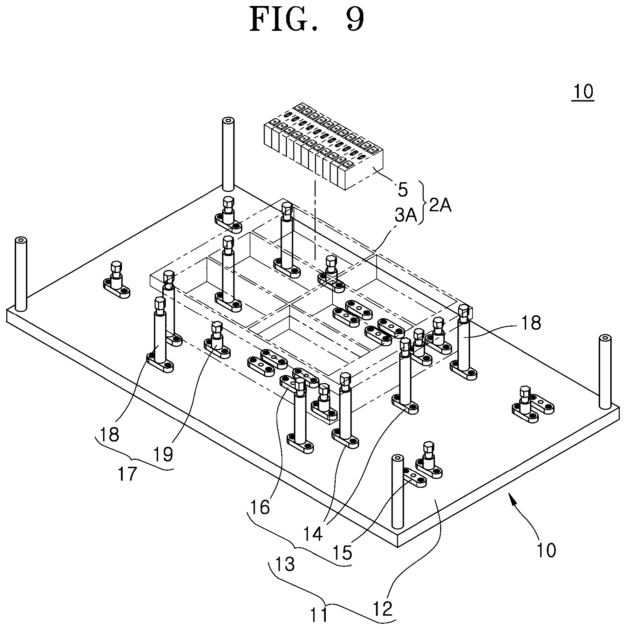

In the description of the present disclosure, battery packs 2 with different specifications will be distinguished and named as a first battery pack 2A, a second battery pack 2B, and a third battery pack 2C, (see FIGS. 9, 11, and 13). In addition, the component 3 provided in the first battery pack 2A, the component 3 provided in the second battery pack 2B, and the component 3 provided in the third battery pack 2C will be distinguished and named as a first component 3A, a second component 3B, and a third component 3C, respectively. The first component 3A, the second component 3B, and the third component 3C may have different sizes or shapes from one another.

Referring to FIG. 1, a position at which a process of changing the positions of the support fixtures 17 provided on the pallet 10 is performed by the support fixture moving device 30 may be named as a first process position. The pallet 10 may be transported by the transfer conveyor 20 from the first process position, at which the support fixture moving device 30 is installed, to a next second process position (not shown), at which another assembly process is performed. At the second process position, the pallet 10 may be stopped, and after an assembly or inspection process performed at the second process position is completed, the pallet 10 may be transported again along the transfer conveyor 20 to a next third process position (not shown).

The pallet 10 may sequentially pass through various process positions for assembling and inspecting the battery pack 2 while being transported along the transfer conveyor 20 as described herein, and may return to the first process position again. One first battery pack 2A may be manufactured through this cycle, and a plurality of first battery packs 2A may be manufactured by repeating this cycle multiple times. The plurality of first battery packs 2A may be manufactured through a single cycle, depending on their size.

Thereafter, when manufacturing the second battery pack 2B with specifications different from those of the first battery pack 2A, the pallet 10 may be transported to the next second process position after the positions of the support fixtures 17 are adjusted by the support fixture moving device 30 at the first process position. Thereafter, the pallet 10 may pass through various process positions for assembling and inspecting the battery pack 2 while being transported along the transfer conveyor 20, and may return to the first process position again. One second battery pack 2B may be manufactured through this cycle, and a plurality of second battery packs 2B may be manufactured by repeating this cycle multiple times. The plurality of second battery packs 2B may be manufactured through a single cycle, depending on their size.

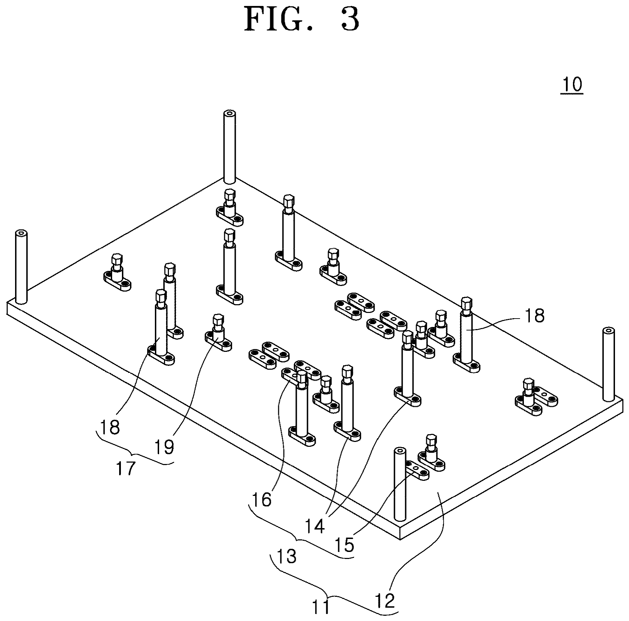

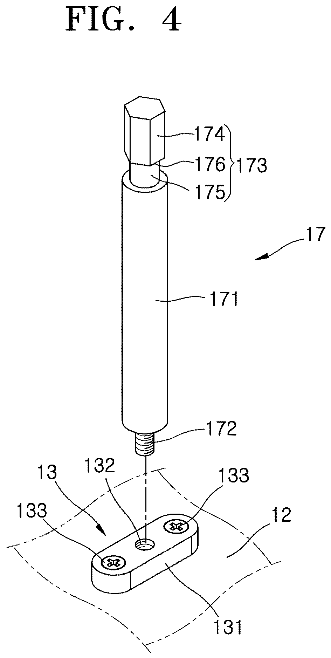

FIG. 3 is a perspective view schematically illustrating the pallet 10 according to embodiments of the present disclosure, and FIG. 4 is a main part exploded perspective view schematically illustrating the support fixture 17 and an installation base 13 according to embodiments of the present disclosure.

Referring to FIGS. 3 and 4, the plate 11 according to embodiments of the present disclosure may include a plate body 12 and an installation base 13.

The plate body 12 may have a panel shape that may be loaded onto the transfer conveyor 20. The plate body 12 may have a rectangular panel shape, and left and right side portions of the plate body 12 may be seated on the pair of transfer rails 21 provided on the transfer conveyor 20. The plate body 12 may have a rigidity capable of supporting the weight of the battery pack 2 and the load acting on the component 3 during the assembly and inspection of the battery pack 2.

The installation base 13 is a device component to which the support fixtures 17 may be detachably coupled, and a plurality of installation bases 13 may be coupled to an upper surface of the plate body 12. The installation base 13 may include an installation base body 131, a fastening groove 132, and a fixing member 133.

The installation base body 131 may have a small block shape capable of fastening and supporting the support fixture 17 and may be disposed on the upper surface of the plate body 12. The installation base body 131 may have a rectangular or elliptical cross-sectional shape. The installation base body 131 may have a lateral width that allows the fastening groove 132 and a pair of fixing members 133 to be disposed in a line. The installation base body 131 may have a vertical height (thickness) that allows the fastening groove 132 to be formed at a predetermined depth.

The fastening groove 132 is a device component to which the support fixture 17 is screwed, and may be formed to be recessed at a central portion of the installation base body 131. A lower portion (a fastening portion 172) of the support fixture 17 may have a male screw structure, and an inner surface of the fastening groove 132 may have a corresponding female screw structure. The fastening groove 132 may be formed on an upper portion of the installation base body 131 to be recessed downwardly, or may be formed to vertically pass through the installation base body 131.

The fixing member 133 fixes the installation base body 131 to the plate body 12. The fixing member 133 has a bolt structure, and may be fastened and fixed to the plate body 12 by passing through the installation base body 131. The pair of fixing members 133 may be provided to respectively fix one side portion and the other side portion of the installation base body 131 in a width direction. The pair of fixing members 133 may be disposed on both sides of the fastening groove 132.

Referring to FIGS. 3 and 4, the support fixture 17 according to embodiments of the present disclosure may include a support bar 171, the fastening portion 172, and a holding portion 173.

The support bar 171 has a rod shape, and may be disposed to protrude upwardly from the plate 11. The support bar 171 may have various lengths and cross-sectional shapes depending on the size and shape of the component 3 to be supported. The support bar 171 may have a rod shape with an overall circular cross-section.

The fastening portion 172 is a device component fastened to the installation base 13, and may be integrally formed with a lower portion of the support bar 171. The fastening portion 172 has a male screw structure, and may be detachably screwed to the fastening groove 132 of the installation base 13. The support bar 171 may be installed and fixed in a shape protruding upwardly from an upper portion of the plate 11, with the fastening portion 172 fastened to the fastening groove 132.

The support fixture 17 may be screwed to the fastening groove 132 of the installation base 13 via the fastening portion 172. Accordingly, the fastened state between the support fixture 17 and the installation base 13 can be released by rotating the support fixture 17, which is in the fastened state with the installation base 13, in a reverse direction (e.g., a counterclockwise direction). When the support fixture 17 is rotated in the reverse direction, the fastening portion 172 gradually moves upwardly in the fastening groove 132 and eventually reaches an upper end of the fastening groove 132, thereby releasing the fastened state between the support fixture 17 and the installation base 13.

Further, the support fixture 17 can be fastened to the installation base 13 by being seated on an upper portion of the installation base 13 and rotated in a forward direction (e.g., a clockwise direction). When the fastening portion 172 is rotated in the forward direction while positioned in contact with an upper portion of the fastening groove 132, the fastening portion 172 may gradually descend along female threads of the fastening groove 132 and be fastened to a predetermined depth.

The holding portion 173 is a device component in contact with a fastening device 31 and a gripper device 32 (to be described herein) of the support fixture moving device 30, and may be integrally formed with an upper portion of the support bar 171. The holding portion 173 may include a rotation holding portion 174, a grip holding portion 175, and a locking step 176.

The rotation holding portion 174 is a device component that engages with the fastening device 31 and has a cross-sectional shape other than a circular cross-sectional shape. The rotation holding portion 174 may have a polygonal cross-sectional shape and may receive a rotational force output from the fastening device 31 while being engaged with the fastening device 31. As the rotation holding portion 174 has a cross-sectional shape other than a circular cross-sectional shape, the rotational force output from the fastening device 31 can be transmitted to the support fixture 17 through the rotation holding portion 174 without loss.

The grip holding portion 175 disposed below the rotation holding portion 174 is a device component held by the gripper device 32, and may be formed to be recessed along a circumference of the support bar 171. As the grip holding portion 175 is formed to be recessed along the circumference of the support bar 171, the locking step 176 may be formed between the rotation holding portion 174 and the grip holding portion 175. The grip holding portion 175 may have a circular cross-sectional shape. As the grip holding portion 175 has a circular cross-sectional shape, and the rotation holding portion 174 has a polygonal cross-sectional shape, the locking step 176 can be formed between the rotation holding portion 174 and the grip holding portion 175.

In a state in which the grip holding portion 175 is clamped by a gripping finger 327 (to be described herein) of the gripper device 32, an upper portion of the gripping finger 327 may be caught by the locking step 176. In other words, in a state in which the grip holding portion 175 is clamped by the gripping finger 327, the locking step 176 of the support fixture 17 may be seated over the upper portion of the gripping finger 327. Accordingly, the support fixture 17 can be constrained and prevented from sliding downwardly or separating from the gripper device 32 while being clamped and moved by the gripper device 32.

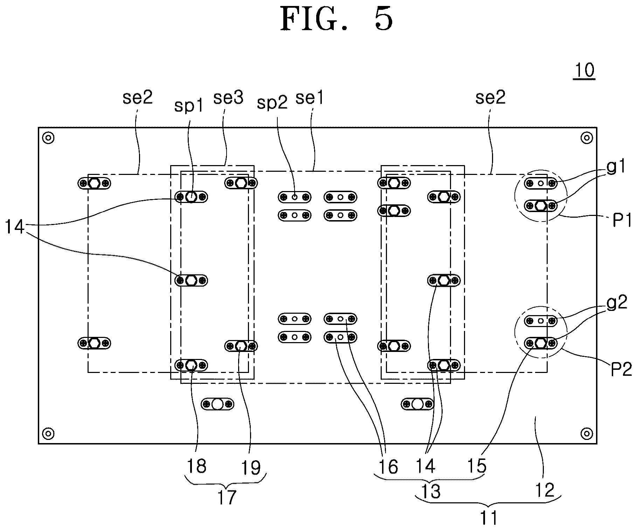

FIG. 5 is a plan view schematically illustrating the pallet 10 according to embodiments of the present disclosure.

Referring to FIG. 5, the pallet 10 according to the present disclosure may include a first region se1 on which the first component 3A of the first battery pack 2A is seated, a second region se2 on which the second component 3B of the second battery pack 2B is seated, and a third region se3 shared by a portion of the first region se1 and a portion of the second region se2.

The plurality of installation bases 13 may be disposed in a distributed manner across the first region se1, the second region se2, and the third region se3. The installation bases 13 may be classified as a first installation base 14, a second installation base 15, and a third installation base 16 depending on the region of installation among the plurality of regions, including the first region se1, the second region se2, and the third region se3. Each of the plurality of support fixtures 17 may be selectively coupled to the first installation base 14, the second installation base 15, and the third installation base 16.

One or more first installation bases 14 may be disposed in the first region se1. The first installation bases 14 may be disposed in the first region se1, one or more first installation bases 14 being positioned in the third region se3. One or more second installation bases 15 may be disposed in the second region se2. The second installation bases 15 may be disposed in the second region se2, one or more second installation bases 15 being positioned in the third region se3. One or more third installation bases 16 may be disposed outside the second region se2. The third installation bases 16 are disposed outside the second region se2, and may be disposed in the first region se1.

The support fixtures 17 may be classified as a first support fixture 18 and a second support fixture 19, depending on whether the support fixture 17 supports the first component 3A or the second component 3B. The support fixtures 17 may be classified as the first support fixture 18 configured to support the first component 3A, and the second support fixture 19 configured to support the second component 3B.

Referring to FIG. 3, the first support fixture 18 and the second support fixture 19 may have different lengths or shapes. When the first component 3A has a larger volume and width than the second component 3B has, the first support fixture 18 may have a longer length than the second support fixture 19 has. For example, the second support fixture 19 may have a shorter length than the first support fixture 18 has to the extent that the second support fixture 19 does not interfere with the first component 3A when the first component 3A is in contact with the first support fixture 18.

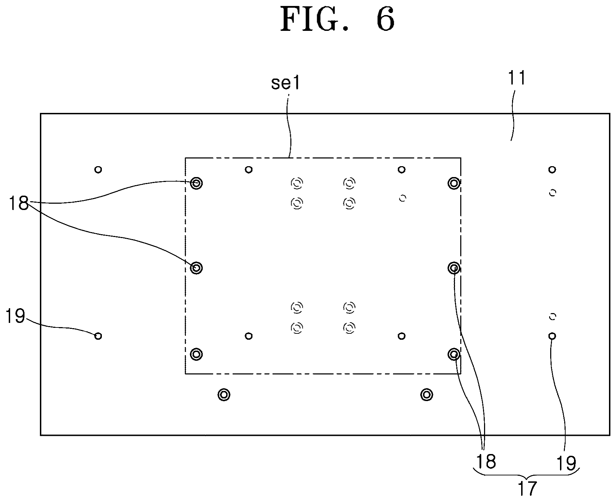

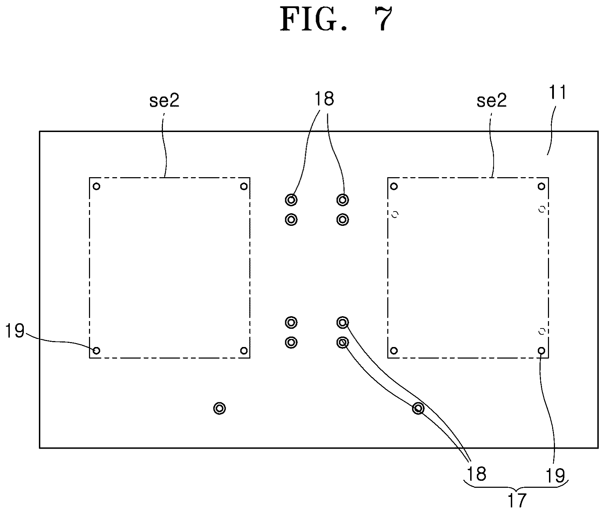

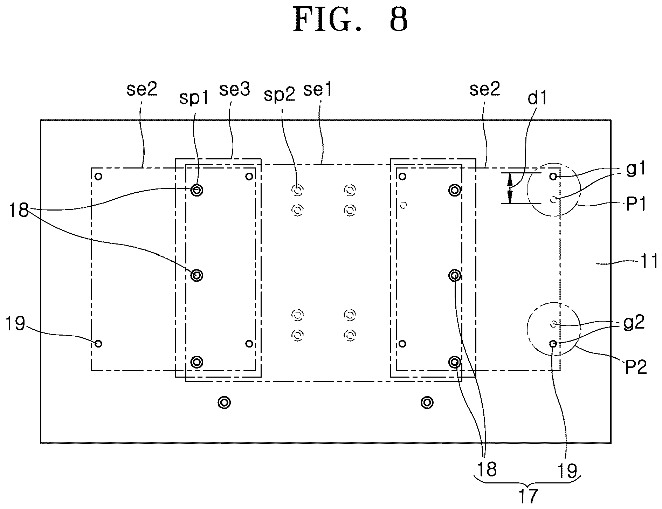

FIG. 6 is a conceptual diagram illustrating the first region se1 of the pallet 10 according to embodiments of the present disclosure, FIG. 7 is a conceptual diagram illustrating the second region se2 of the pallet 10 according to embodiments of the present disclosure, and FIG. 8 is a conceptual diagram illustrating the first region se1, the second region se2, and the third region se3 of the pallet 10 according to embodiments of the present disclosure.

To make it easier to distinguish between the first support fixtures 18 and the second support fixtures 19, in FIGS. 6 to 8, the first support fixtures 18 are represented by ⊚, the second support fixtures 19 are represented by O, and the installation bases 13 are omitted.

Referring to FIGS. 6 and 8, the first component 3A may have a width greater than half a width of the plate 11. The first component 3A may be placed at a central portion of the pallet 10. A region in which the first component 3A is placed may be set as the first region se1. The first component 3A may be supported by a plurality of first support fixtures 18 disposed in the first region se1.

At this time, some of the plurality of first support fixtures 18 may be positioned in the third region se3. Further, the first support fixtures 18 may also be disposed at positions corresponding to edges of the first component 3A. At least some of the plurality of first support fixtures 18 may be positioned to correspond to corners of the first component 3A.

Referring to FIGS. 7 and 8, the second component 3B may have a width smaller than half the width of the plate 11. A plurality of second components 3B may be placed on the pallet 10. Two second components 3B may be placed in parallel in a direction in which the transfer conveyor 20 is transported (e.g., in a front-rear direction). A region in which the second component 3B is placed may be set as the second region se2. The second component 3B may be supported by a plurality of second support fixtures 19 disposed in the second region se2.

At this time, some of the plurality of second support fixtures 19 may be positioned in the third region se3. Further, the second support fixtures 19 may be disposed at positions corresponding to edges of the second component 3B. At least some of the plurality of second support fixtures 19 may be positioned to correspond to corners of the second component 3B.

FIG. 9 is a perspective view illustrating a state in which the first component 3A is seated on the first region se1 of the pallet 10 according to embodiments of the present disclosure.

During the manufacturing of the first battery pack 2A, at the first process position in which the support fixture moving device 30 is installed, the plurality of first support fixtures 18 may be positioned in the first region se1 of the pallet 10, as shown in FIGS. 3 and 6. At this time, as shown in FIG. 8, some of the first support fixtures 18 may be positioned in the third region se3.

Thereafter, the pallet 10 may be transported to the second process position by the transfer conveyor 20. When the pallet 10 reaches the second process position, the first component 3A may be loaded onto the pallet 10 as indicated by a dash-double dotted line in FIG. 9, and may come into contact with the plurality of first support fixtures 18 to constrain its movement in a horizontal direction (in front-back and left-right directions). The first component 3A may be the housing 4 of the first battery pack 2A. In this case, the plurality of first support fixtures 18, among the plurality of support fixtures 17, may effectively perform the function of coming into contact with the first component 3A and constraining the movement of the first component 3A.

In a state in which the first component 3A is positioned in the first region se1 as described herein, among the plurality of second support fixtures 19, the second support fixtures 19 that are disposed in the third region se3 may be positioned below the first component 3A. At this time, the second support fixture 19 may be shorter in length than the first support fixture 18 so as not to interfere with the first component 3A. In a state in which the first component 3A is in contact with and supported by the first support fixtures 18, a bottom surface of the first component 3A may be elevated above the second support fixtures 19 disposed in the third region se3.

In addition, in a state in which flange portions formed on front and rear portions of the first component 3A are in contact with and supported by the first support fixtures 18, the bottom surface of the first component 3A, which is positioned below the flange portions, may come into contact with the second support fixtures 19 disposed in the third region se3 and may be held and supported by the second support fixtures 19. By forming the second support fixture 19 shorter in length than the first support fixture 18 as described herein, the process of moving the second support fixtures 19 disposed in the third region se3 to the outside of the first region se1 during the assembly of the first component 3A can be omitted.

The first component 3A may have a rectangular parallelepiped box shape and may have a width greater than half the width of the plate 11. The plurality of first support fixtures 18 may be arranged along the front and rear portions of the first component 3A. Referring to FIGS. 8 and 9, three first support fixtures 18 may be in contact with the front portion of the first component 3A, and three first support fixtures 18 may be in contact with the rear portion of the first component 3A. By coming into contact with the plurality of first support fixtures 18 at multiple points as described herein, the first component 3A can be supported by the first support fixtures 18 while simultaneously being constrained in its movement.

A groove may be formed on a portion of the first component 3A, which is in contact with the first support fixture 18, and an upper portion of the first support fixture 18 may be inserted into the groove. The first component 3A may be constrained in its horizontal movement by being caught on the first support fixtures 18 fitted into the groove.

Referring to FIG. 9, four second support fixtures 19 may be positioned in the third region se3, and when the first component 3A is positioned in the first region se1, the edges of the first component 3A may be supported by six first support fixtures 18, and simultaneously, the rectangular bottom surface of the first component 3A may be supported by the four second support fixtures 19. At this time, a groove corresponding in shape to an upper portion of the second support fixture 19 may be formed in the portion of the first component 3A that comes into contact with the second support fixture 19, and the second support fixture 19 may be inserted into the groove. The first component 3A may be constrained in its horizontal movement by being caught on the first support fixture 18 and the second support fixture 19 fitted into the groove.

Thereafter, with the first component 3A loaded on the pallet 10, the pallet 10 may be transported to the third process position by the transfer conveyor 20. When the pallet 10 reaches the third process position, a plurality of battery cells 5 may be accommodated and assembled to the first component 3A, as depicted by the dash-double dotted line in FIG. 9. Thereafter, the first battery pack 2A may undergo further assembly processes to be manufactured and completed.

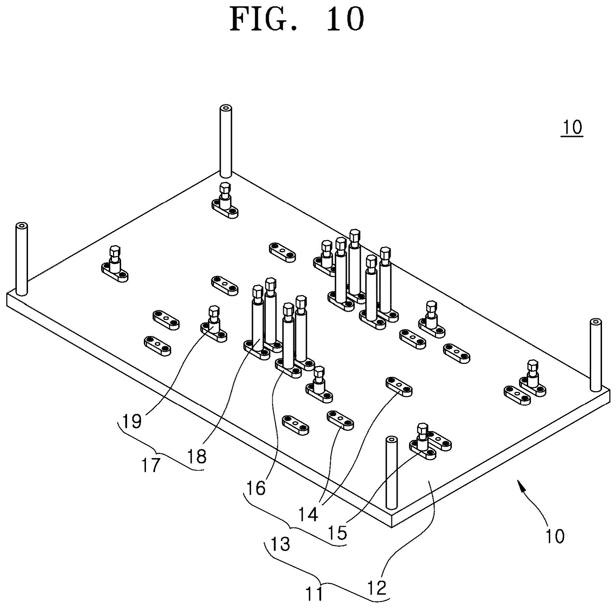

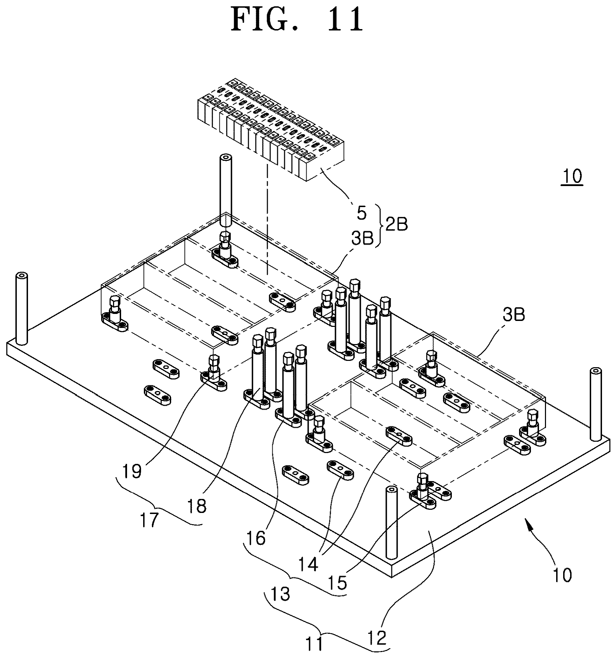

FIG. 10 is a perspective view schematically illustrating another example of the plate 11 according to embodiments of the present disclosure, and FIG. 11 is a perspective view illustrating a state in which the second component 3B is seated on the second region se2 of the pallet 10 according to embodiments of the present disclosure.

Thereafter, the plurality of first support fixtures 18 positioned in the third region se3 during the manufacture of the second battery pack 2B using the same pallet 10 may be moved outside the second region se2 at the first process position in which the support fixture moving device 30 is installed. The plurality of first support fixtures 18, which were coupled to the first installation base 14 on the third region se3 during the manufacture of the first battery pack 2A, may be repositioned and coupled to the third installation base 16 during the manufacture of the second battery pack 2B.

At this time, the plurality of first support fixtures 18, which were fastened to the first installation bases 14 as shown in FIGS. 3 and 6, may be unfastened from the first installation bases 14 and then moved toward and fastened to the third installation bases 16 by the support fixture moving device 30, as shown in FIGS. 7 and 10.

Thereafter, the pallet 10 may be transported to the second process position by the transfer conveyor 20. When the pallet 10 reaches the second process position, the second component 3B may be loaded onto the pallet 10 as indicated by a dash-double dotted line in FIG. 11, and may come into contact with the plurality of second support fixtures 19 to constrain its movement in the horizontal direction (in the front-back and left-right directions). The second component 3B may be the housing 4 of the second battery pack 2B. In this case, the plurality of second support fixtures 19, among the plurality of support fixtures 17, may effectively perform the function of coming into contact with the second component 3B and constraining the movement of the second component 3B.

The second component 3B may have a rectangular parallelepiped box shape, with a width smaller than half of the width of the plate 11, and two second components 3B may be placed on the pallet 10. The two second components 3B may be placed to be spaced apart from one another in the front-rear direction. The plurality of second support fixtures 19 may be disposed at positions corresponding to corners of the second components 3B.

Referring to FIGS. 8 and 11, four second support fixtures 19 may be respectively in contact with the corners of one second component 3B, and four second support fixtures 19 may be respectively in contact with the corners of another second component 3B. By coming into contact with the plurality of second support fixtures 19 at multiple points as described herein, the two second components 3B may be supported by the second support fixtures 19 while simultaneously being constrained in their movement.

A groove may be formed in a portion of the second component 3B, which is in contact with the second support fixture 19, and the upper portion of the second support fixture 19 may be inserted into the groove. The second components 3B may be constrained in their horizontal movement by being caught on the second support fixtures 19 fitted into the groove.

Subsequently, with the second component 3B loaded on the pallet 10, the pallet 10 may be transported to the third process position by the transfer conveyor 20. When the pallet 10 reaches the third process position, the plurality of battery cells 5 may be accommodated and assembled in the second component 3B as indicated by the dash-double dotted line in FIG. 11. Thereafter, the second battery pack 2B may undergo further assembly processes to be manufactured and completed.

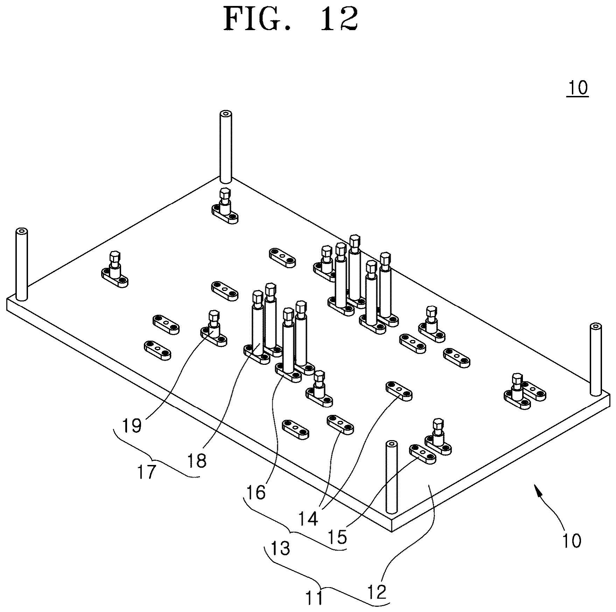

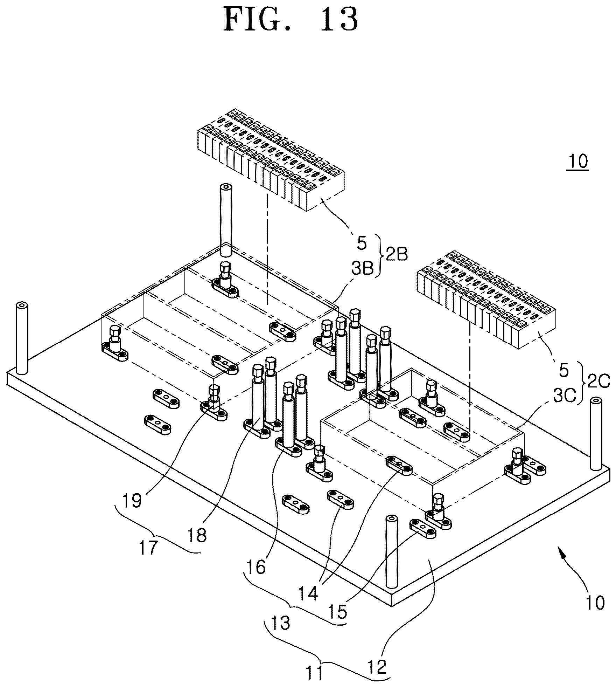

FIG. 12 is a perspective view schematically illustrating still another example of the plate 11 according to embodiments of the present disclosure, and FIG. 13 is a perspective view illustrating a state in which the third component 3C is seated on the second region se2 of the pallet 10 according to embodiments of the present disclosure.

Referring to FIG. 8, some of the plurality of installation bases 13 may be densely disposed within a group setting distance d1 to form groups g1 and g2. The groups g1 and g2 of the installation bases 13 may be formed as one group or as a plurality of groups in the first region and the second region. The groups g1 and g2 of the installation bases 13 may be formed at positions corresponding to the edges of the first component 3A and may also be formed at positions corresponding to the edges of the second component 3B.

As an example, the installation bases 13 may be arranged to form a first group g1 and a second group g2. The first group g1 may be formed by arranging a plurality of second installation bases 15 within the group setting distance d1 on a first position P1, which is one of the corners of the second component 3B. The second group g2 may be formed by arranging a plurality of second installation bases 15 within the group setting distance d1 on a second position P2, which is another one of the corners of the second component 3B.

The first group g1 may be formed by arranging two installation bases 13 in parallel in the left-right direction. The second group g2 may be formed by arranging two installation bases 13 in parallel in the left-right direction. A separation distance between the first position P1 and the second position P2 may be greater than the group setting distance d1.

When manufacturing the second battery pack 2B, the second support fixture 19 may be fastened to one of the plurality of second installation bases 15 that form the first group g1. In addition, the second support fixture 19 may be fastened to one of the plurality of second installation bases 15 that form the second group g2. When manufacturing the third battery pack 2C, the second support fixture 19 may be moved to another one of the plurality of second installation bases 15 forming the first group g1 and fastened thereto by the support fixture moving device 30. In addition, the second support fixture 19 may be moved and fastened to another one of the plurality of second installation bases 15 that form the second group g2.

When the second battery pack 2B and the third battery pack 2C each have a width smaller than half of the width of the plate 11, two or more second components 3B or third components 3C may be loaded on the pallet 10. In addition, one or more second components 3B and one or more third components 3C may be loaded together on the pallet 10.

The third component 3C may have a shape or size different from that of the second component 3B. For example, the third component 3C may have the same rectangular parallelepiped shape as the second component 3B while having a smaller front-rear width than the second component 3B.

In a case in which the second component 3B has a larger left-right width than the third component 3C, when manufacturing the plurality of second battery packs 2B using one pallet 10, the second support fixture 19 may be fastened to the second installation base 15 within the first group g1, as shown in FIGS. 10 and 11, the second installation base 15 being relatively closer to a left or right edge of the pallet 10. In addition, the second support fixture 19 may be fastened to the second installation base 15 within the second group g2, the second installation base 15 being relatively close to the left or right edge of the pallet 10.

When simultaneously manufacturing the second battery pack 2B and the third battery pack 2C using the same pallet 10 after manufacturing the second battery pack 2B, the second support fixture 19 may be moved to the second installation base 15 within the first group g1 and fastened thereto by the support fixture moving device 30, as shown in FIGS. 12 and 13, the second installation base 15 being relatively spaced apart from the left or right edge of the pallet 10. In addition, the second support fixture 19 may be moved and fastened to the second installation base 15 within the second group g2, the second installation base 15 being relatively spaced apart from the left or right edge of the pallet 10. Accordingly, a left-right distance between the second support fixtures 19 positioned at the first position P1 and the second position P2 may be further reduced.

Thereafter, the pallet 10 may be transported to the second process position by the transfer conveyor 20. When the pallet 10 reaches the second process position, the second component 3B and the third component 3C may be loaded onto the pallet 10 as indicated by a dash-double dotted line in FIG. 13, and may come into contact with the plurality of second support fixtures 19 to constrain their movement in the horizontal direction (in the front-back and left-right directions). At this time, the third component 3C may come into contact with the second support fixtures 19 positioned at the first position P1 and the second position P2. The second component 3B may be the housing 4 of the second battery pack 2B, and the third component 3C may be the housing 4 of the third battery pack 2C.

The second component 3B may have a rectangular parallelepiped box shape, with a width smaller than half of the width of the plate 11, and may be placed on the rear portion of the pallet 10. The third component 3C may have a rectangular parallelepiped box shape, with a smaller width than the second component 3B, and may be placed on the front portion of the pallet 10. The plurality of second support fixtures 19 may be disposed at positions corresponding to corners of each of the second component 3B and the third component 3C.

Four second support fixtures 19 may be respectively in contact with the corners of the second component 3B, and four second support fixtures 19 may be respectively in contact with the corners of the third component 3C. By coming into contact with the plurality of second support fixtures 19 at multiple points as described herein, the second component 3B and the third component 3C may be supported by the second support fixtures 19 while simultaneously being constrained in their movement.

A groove may be formed in the portion of each of the second component 3B and the third component 3C, which is in contact with the second support fixture 19, and the upper portions of the second support fixtures 19 may be inserted into the grooves. The second component 3B and the third component 3C may be constrained in their horizontal movement by being caught on the second support fixtures 19 fitted into the grooves.

Subsequently, with the second component 3B and the third component 3C loaded together on the pallet 10, the pallet 10 may be transported to the third process position by the transfer conveyor 20. When the pallet 10 reaches the third process position, the plurality of battery cells 5 may be accommodated and assembled in the second component 3B and the third component 3C, as indicated by the dash-double dotted line in FIG. 13. The second battery pack 2B and the third battery pack 2C may undergo further assembly processes to be simultaneously manufactured and completed.

According to the present disclosure, some of the support fixtures 17 may be moved to the inside and outside of each of the first region se1, the second region se2, and the third region se3 as shown in FIGS. 5 to 11. By undergoing the process of changing the arrangement of the support fixtures 17 as described herein, various battery packs 2 with different specifications can be manufactured using the same pallet 10.

Further, according to the present disclosure, some of the support fixtures 17 positioned in each of the first region se1, the second region se2, and the third region se3 can be slightly moved by a distance within the group setting distance d1, as shown in FIGS. 10 to 13. By undergoing the process of changing the arrangement of the support fixtures 17 as described herein, various battery packs 2 with different specifications can be manufactured using the same pallet 10.

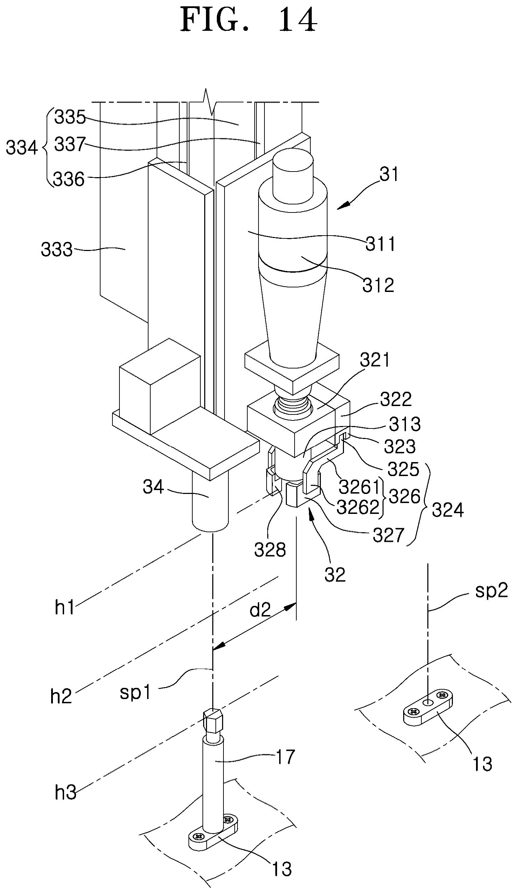

FIG. 14 is a main part perspective view schematically illustrating the support fixture moving device 30 according to embodiments of the present disclosure.

Referring to FIGS. 1 and 14, the support fixture moving device 30 may include the fastening device 31, the gripper device 32, a moving device 33, a detection device 34, and a control device 35.

The fastening device 31 may fasten or unfasten the support fixture 17 to or from the installation base 13 of the plate 11 by rotating the support fixture. The fastening device 31 may include a nutrunner. The fastening device 31 may output a rotational force in the forward or reverse direction while being in contact and engaged with the rotation holding portion 174 formed on the upper portion of the support fixture 17.

Referring to FIGS. 1, 4, and 14, the fastening device 31 may include a first support 311, a first actuator 312, and a socket 313.

The first support 311 is a device component of the fastening device 31, which forms a support frame configured to support the first actuator 312 and the socket 313. The first support 311 may be installed on a third moving body 334 (to be described herein) of the moving device 33 to be movable up and down. The installation of the first support 311 on the third moving body 334 to be movable is not limited to a specific structure or shape, including known techniques such as a linear guide that generates linear displacement, and thus, a detailed description thereof is omitted.

The first actuator 312 may be fixedly installed on the first support 311 and may output a forward rotational force and a reverse rotational force. The first actuator 312 may include a servo motor. The first actuator 312 may be installed to extend vertically, and may have a lower portion at which an output shaft (not shown) may be disposed. The first support 311 may have a panel, block, or rod shape, and may be disposed to extend vertically in a manner capable of supporting the first actuator 312 and the socket 313.

The socket 313 is a device component of the fastening device 31, which transmits the rotational force of the first actuator 312 to the support fixture 17. The socket 313 may be connected to the output shaft of the first actuator 312. The socket 313 may engage with the rotation holding portion 174 of the support fixture 17 when the fastening device 31 descends. A downwardly open groove (not shown) with a size and cross-sectional shape corresponding to the rotation holding portion 174 may be formed in the socket 313.

When the rotation holding portion 174 has a polygonal cross-sectional shape, the groove of the socket 313 may have a corresponding polygonal cross-sectional shape. Since an inner surface of each of the rotation holding portion 174 and the socket 313 has a cross-sectional shape other than a circular cross-sectional shape, the rotational force output from the first actuator 312 may be transmitted to the support fixture 17 through the rotation holding portion 174 without loss.

When the first support 311 descends, the first actuator 312 and the socket 313 also descend with the same displacement as the first support 311, which allows the socket 313 to engage with the rotation holding portion 174 of the support fixture 17. At this time, the rotation holding portion 174 may be inserted and engaged with the groove formed in the socket 313. When the first actuator 312 operates in the forward direction, the socket 313 can rotate in the forward direction, and a rotational force of the socket 313 is transmitted to the support fixture 17, thereby allowing the support fixture 17 to rotate in the forward direction. The support fixture 17 may be screwed onto the installation base 13 when rotated in the forward direction.

When the first actuator 312 operates in the reverse direction, the socket 313 can rotate in the reverse direction, and a rotational force of the socket 313 is transmitted to the support fixture 17, thereby allowing the support fixture 17 to rotate in the reverse direction. The support fixture 17 is rotated in the reverse direction to release the screw-fastening with the installation base 13 and may be separated from the installation base 13.

The gripper device 32 may clamp or unclamp the support fixture 17. The support fixture 17 may be clamped by the gripper device 32 after being unfastened from the installation base 13 by the fastening device 31 and may be moved to a desired set position while remaining clamped by the gripper device 32. In addition, the support fixture 17 may be unclamped by the gripper device 32 after reaching the desired set position.

Referring to FIGS. 1, 4, and 14, the gripper device 32 may include a second support 321, a second actuator 322, a guide block 323, a first gripper 324, and a second gripper 328.

The second support 321 is a device component of the gripper device 32, which forms a support frame that supports the second support 321, the second actuator 322, the guide block 323, the first gripper 324, and the second gripper 328. The second support 321 may be installed on the moving device 33. The second support 321 may be installed on the moving device 33 through the first support 311.

The second support 321 may be fixedly installed on the first support 311. By fixedly installing the second support 321 on the first support 311, the first support 311 and the second support 321 may be moved together with the same displacement. The first support 311 and the second support 321 may be moved together with the same displacement when the third moving body 334 moves.

The fact that the first support 311 and the second support 321 are moved vertically together with the same displacement means that the fastening device 31 and the gripper device 32 are moved together with the same displacement. By fixedly installing the second support 321 on the first support 311, the fastening device 31 and the gripper device 32 may be moved together with the same displacement. Accordingly, the socket 313, the first gripper 324, and the second gripper 328 may always maintain the same relative positions and distances.

The second support 321 may have a block shape, and may be disposed below the first actuator 312 to extend across the socket 313 in the horizontal direction. A hole through which the socket 313 may pass may be formed in the second support 321, and the socket 313 may extend downwardly from the second support 321 by passing through the second support 321 through the hole. A clearance is provided between an edge of the hole in the second support 321 and the socket 313 to ensure that the second support 321 does not interfere with the rotation of the socket 313.

As an extension length of each of the first gripper 324 and the second gripper 328 becomes shorter, a gripping force acting on the first gripper 324 and the second gripper 328 may be transmitted more stably to the grip holding portion 175 of the support fixture 17. By disposing the second support 321 at the position corresponding to the socket 313 as described herein, the guide block 323, on which the first gripper 324 and the second gripper 328 are installed, can be positioned closer to a lower portion of the socket 313, and this arrangement can further reduce the extension length of each of the first gripper 324 and the second gripper 328, extending from the guide block 323 to the grip holding portion 175 of the support fixture 17.

The second actuator 322 having a block shape may come into surface-contact with and be fixedly installed on a side surface of the second support 321, and may output a hydraulic or pneumatic pressure. The second actuator 322 may include a pneumatic cylinder. The second actuator 322 may output a pressing force that moves the first gripper 324 and the second gripper 328 closer to or farther away from one another.

The guide block 323 may be a device component on which the first gripper 324 and the second gripper 328 are installed, and may have a block shape and be mounted on the second support 321. The guide block 323 may be installed on the second support 321 through the second actuator 322. The guide block 323 may be brought into surface-contact with and fixedly installed on a bottom surface of the second actuator 322.

The guide block 323 may movably support the first gripper 324 and the second gripper 328. The guide block 323 may have a rail (not shown) formed to guide a linear movement of the first gripper 324 and the second gripper 328, and at least one of the first gripper 324 and the second gripper 328 may be installed to be movable along the rail.

The first gripper 324 and the second gripper 328 may be installed on the guide block 323 and may be disposed to face one another with the socket 313 therebetween. A distance between the first gripper 324 and the second gripper 328 may be varied by the operation of the second actuator 322.

An elastic member (not shown), which elastically presses the first gripper 324 and the second gripper 328 in directions away from one another, may be installed on the guide block 323. At least one of the first gripper 324 or the second gripper 328 may be installed while being elastically pressed by the elastic member.

When the second actuator 322 is operated (turned on), a hydraulic or pneumatic pressure acts on at least one of the guide block 323, the first gripper 324, and the second gripper 328, and at least one of the first gripper 324 and the second gripper 328 may move in a direction closer to the other one. As a result of this action, the first gripper 324 and the second gripper 328 may reduce a distance therebetween to clamp the support fixture 17 together.

When the second actuator 322 is not operated (turned off), the hydraulic or pneumatic pressure does not act on at least one of the guide block 323, the first gripper 324, and the second gripper 328, and at least one of the first gripper 324 and the second gripper 328 may move in a direction away from the other one due to the elastic restoring force of the elastic member. As a result of this action, the first gripper 324 and the second gripper 328 may increase the distance therebetweeen to unclamp the support fixture 17.

The first gripper 324 may include a block connection portion 325, an extension portion 326, and the gripping finger 327.

The block connection portion 325 is a device component that forms an upper portion of the first gripper 324, and may be movably installed on the guide block 323. The block connection portion 325 may be installed to be reciprocally movable in a direction toward or away from the second gripper 328.

The extension portion 326 is a device component that forms an intermediate portion of the first gripper 324, and may extend downwardly from the block connection portion 325 to a lower side of the socket 313. The extension portion 326 may include a first extension portion 3261 extending horizontally and a second extension portion 3262 extending vertically.

The first extension portion 3261 is a device component that forms an upper portion of the extension portion 326, and may extend rearward from the block connection portion 325, which is positioned in front of the socket 313, toward the socket 313. A rear end portion of the first extension portion 3261 may be positioned on a left or right side of the socket 313. The second extension portion 3262 is a device component that forms a lower portion of the extension portion 326, and may extend downwardly parallel to the socket 313 from the rear end portion of the first extension portion 3261. The lower portion of the second extension portion 3262 may be positioned below the socket 313.

As such, the extension portion 326 may have an "L" shape, with the upper portion extending horizontally and the lower portion extending vertically. Accordingly, the lower portion of the extension portion 326 may be positioned as close as possible to the socket 313 and may extend downwardly parallel to the socket 313. Accordingly, when lowering the fastening device 31 and the gripper device 32 together to perform a process of engaging the lower portion of the socket 313 with the support fixture 17, the extension portion 326 can be prevented from interfering with the adjacent support fixtures 17 even when the support fixtures 17 are positioned close to one another.

The gripping finger 327 is a device component that forms a lower portion of the first gripper 324, and may have a shape capable of being in contact with at least a portion of a circumference of the support fixture 17 and be connected to the lower portion of the extension portion 326. The gripping finger 327 may be disposed below the socket 313 and may be positioned to face the grip holding portion 175 of the support fixture 17 while the lower portion of the socket 313 engages with the rotation holding portion 174 of the support fixture 17. The portion of the gripping finger 327 that faces the grip holding portion 175 may have an arc shape corresponding to a portion of a circumference of the grip holding portion 175.

The locking step 176 may be formed between the rotation holding portion 174 and the grip holding portion 175 of the support fixture 17. In a state in which the gripping finger 327 clamps the grip holding portion 175, the upper portion of the gripping finger 327 may be caught on the locking step 176. In a state in which the gripping finger 327 is in contact with the grip holding portion 175 to clamp the support fixture 17, the locking step 176 may be seated over the upper portion of the gripping finger 327. Accordingly, the support fixture 17 can be constrained and prevented from sliding downwardly or separating from the gripping finger 327 while being clamped and moved by the gripping finger 327.

Similar to the first gripper 324, the second gripper 328 may include the block connection portion 325, the extension portion 326, and the gripping finger 327, and may have a structure symmetrical to the first gripper 324 with respect to the socket 313. The second gripper 328 has a structure that is symmetrical and corresponding to that of the first gripper 324, and a detailed description of the structure and operation of the second gripper 328 will be replaced with the description for the first gripper 324.

The moving device 33 may move the support fixture 17, which is gripped by the gripper device 32, to a first set position sp1 or a second set position sp2 on the pallet 10. The moving device 33 may have a structure capable of moving the fastening device 31 and the gripper device 32 in a first direction, a second direction, and a third direction that are mutually orthogonal to one another. The first direction may be the left-right direction, the second direction may be the front-rear direction, and the third direction may be an up-down direction.

Referring to FIGS. 1 and 14, the moving device 33 may include a guide bar 331, a first moving body 332, a second moving body 333, and the third moving body 334.

The guide bar 331 may be formed to extend in the first direction. The guide bar 331 may be disposed above the pallet 10, may have a rod shape, and may be disposed as a pair parallel to one another. The pair of guide bars 331 may be formed to extend in the left-right direction. One of the pair of guide bars 331 may be disposed to extend in the left-right direction in front of the pallet 10. The other one of the pair of guide bars 331 may be disposed to extend in the left-right direction in the rear of the pallet 10.

The first moving body 332 may be formed to extend in the second direction, and may be installed on the guide bar 331 to be movable in the first direction. The first moving body 332 may have a rod shape that extends entirely in the front-rear direction, and may have a front end portion and a rear end portion that are movably connected to the pair of guide bars 331, respectively. The installation of the first moving body 332 on the guide bars 331 to be movable is not limited to a specific structure or shape, including known techniques such as a linear guide that generates linear displacement, and thus, a detailed description thereof is omitted.

The second moving body 333 may be formed to extend in the third direction, and may be installed on the first moving body 332 to be movable in the second direction. The second moving body 333 may have a rod shape that extends entirely in the up-down direction, and may be connected to the first moving body 332 to be movable up and down. The installation of the second moving body 333 on the first moving body 332 to be movable is not limited to a specific structure or shape, including known techniques such as a linear guide that generates linear displacement, and thus, a detailed description thereof is omitted.

The third moving body 334 is a device component that forms a support frame configured to support the fastening device 31, the gripper device 32, and the detection device 34. The third moving body 334 may be installed on the second moving body 333 to be movable up and down in the third direction. The fastening device 31, the gripper device 32, and the detection device 34 may be movably installed on the third moving body 334.

The third moving body 334 may include an elevating body 335, a first rail 336, and a second rail 337.

The elevating body 335 is a device component that forms a basic frame of the third moving body 334, and may be installed on the second moving body 333 to be movable up and down in the third direction. The first rail 336 is a device component that guides the vertical movement of the detection device 34, and may be formed to extend vertically along one side portion of the elevating body 335. The second rail 337 is a device component that guides the vertical movement of the fastening device 31 and the gripper device 32, and may be formed to extend vertically along the other side portion of the elevating body 335. The second rail 337 may be disposed parallel to the first rail 336 with a separation distance.

The detection device 34 may be installed on the first rail 336 to be movable up and down. The fastening device 31 and the gripper device 32 may be installed together on the second rail 337 to be movable up and down. The fastening device 31 may include the first support 311 that is movably installed on the first rail 336, and the gripper device 32 may include the second support 321 that is installed on the first support 311. By installing the first support 311 on the second rail 337 to be movable up and down, the fastening device 31 and the gripper device 32 can also be installed together on the second rail 337 to be movable up and down. As described herein, the detection device 34 and the first support 311 may be separately manufactured and installed on the first rail 336 and the second rail 337, respectively, to be movable up and down.

Accordingly, even when an impact force acts on the detection device 34 due to contact or collision with the support fixture 17, the impact force can be absorbed at the connection portion between the detection device 34 and the first rail 336, thereby preventing the impact force from being transmitted to the elevating body 335 and the first support 311. A cushioning member (not shown) capable of absorbing an impact force may be provided on the connection portion between the detection device 34 and the first rail 336.

Further, even when an impact force acts on the fastening device 31 or the gripper device 32 due to contact or collision with the support fixture 17, the impact force can be absorbed at the connection portion between the first support 311 and the second rail 337, thereby preventing the impact force from being transmitted to the elevating body 335 and the detection device 34. A cushioning member (not shown) capable of absorbing an impact force may be provided on the connection portion between the first support 311 and the second rail 337.

The installation of the first moving body 332, the second moving body 333, and the third moving body 334 to be movable along the rail is not limited to a specific structure or shape, including known techniques such as linear guides that generate linear displacement, and thus a detailed description thereof is omitted. In addition, although the rail is illustrated in a recessed form in the drawings of the present disclosure, this is merely an example to illustrate a specific example of the rail and is not intended to be limiting. The rail of the present disclosure is not limited to a specific structure and shape, including a recessed form, a protruding form, the form of a linear rod, and the like.

The detection device 34 is a device component that detects a position of the support fixture 17 mounted on the pallet 10. The detection device 34 may be disposed at a set distance d2 in the front-rear direction from the fastening device 31 and the gripper device 32. A contact sensor or a non-contact sensor may be selectively applied to the detection device 34. As an example, a contact sensor that is in direct contact with the support fixture 17 may be applied to the detection device 34.

By applying a contact sensor as the detection device 34, when the detection device 34 descends, a lower portion of the detection device 34 comes into direct contact with the support fixture 17, thereby minimizing detection errors or faults. As long as the detection device 34 can detect the position of the support fixture 17, it is not limited to a specific structure or shape, including known technologies such as vision cameras, and thus, detailed descriptions of its structure and operation are omitted.

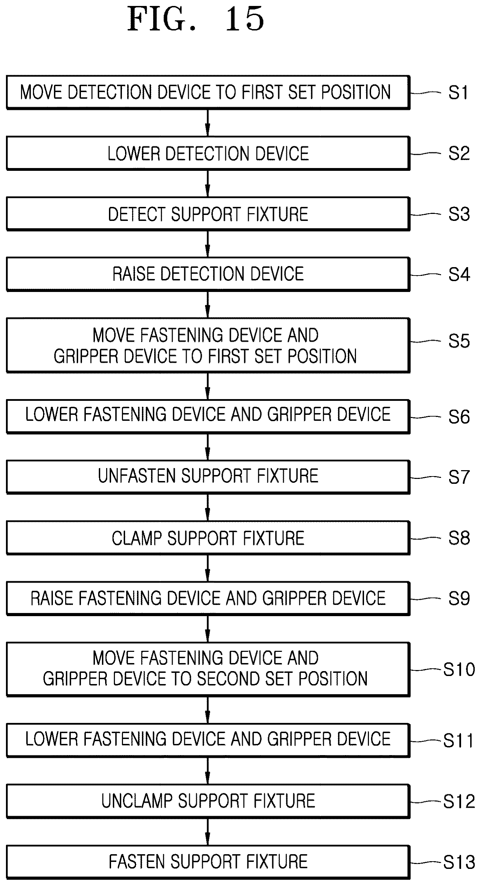

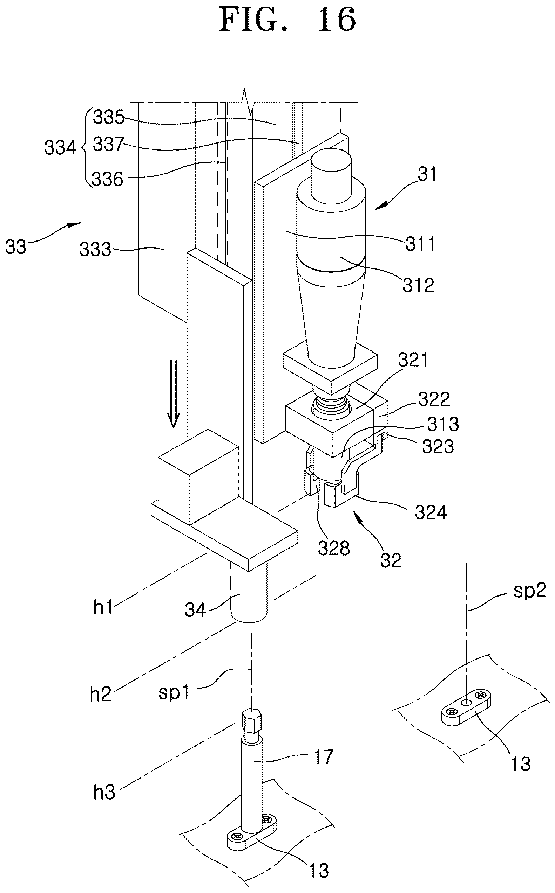

FIG. 15 is a flowchart illustrating a process of moving the support fixture 17 from the first set position to the second set position using the support fixture moving device 30 according to embodiments of the present disclosure, and FIGS. 16 to 21 are conceptual diagrams illustrating the process of moving the support fixture 17 from the first set position to the second set position using the support fixture moving device 30 according to embodiments of the present disclosure.

The control device 35 may control operations of the fastening device 31, the gripper device 32, and the moving device 33. The control device 35 may control the operations of the fastening device 31, gripper device 32, and moving device 33 according to pre-input information of the battery pack 2 or input commands. The control device 35 may receive information or commands on which of the first battery pack 2A, the second battery pack 2B, and the third battery pack 2C is being manufactured, and may control the operations of the fastening device 31, the gripper device 32, and the moving device 33 so that the support fixtures 17 are disposed to correspond to each of the first battery pack 2A, the second battery pack 2B, and the third battery pack 2C.

Further, the control device 35 may determine positions of the support fixtures 17 based on the detection information from the detection device 34, and may control the operations of the fastening device 31, the gripper device 32, and the moving device 33. Referring to FIG. 15, when the control device 35 detects, through the detection device 34, that the support fixture 17 is positioned at the first set position sp1, the control device 35 may control the fastening device 31, the gripper device 32, and the moving device 33 to unfasten the support fixture 17 at the first set position sp1, move the support fixture 17 to the second set position sp2, and fasten the support fixture 17 at the second set position sp2.

The control device 35 may control the operations of the fastening device 31, the gripper device 32, and the moving device 33 to sequentially perform processes of detecting the support fixture 17 at the first set position sp1 using the detection device 34, unfastening the support fixture 17 using the fastening device 31, gripping the support fixture 17 using the gripper device 32 to separate the support fixture 17 from the plate 11, and moving the support fixture 17 to the second set position sp2 to fasten the support fixture 17 to the plate 11.

The process of detecting the support fixture 17 on the first set position sp1 using the detection device 34 may be performed sequentially through a first moving operation (S1), a first descending operation (S2), a support fixture detection operation (S3), and a first ascending operation (S4).

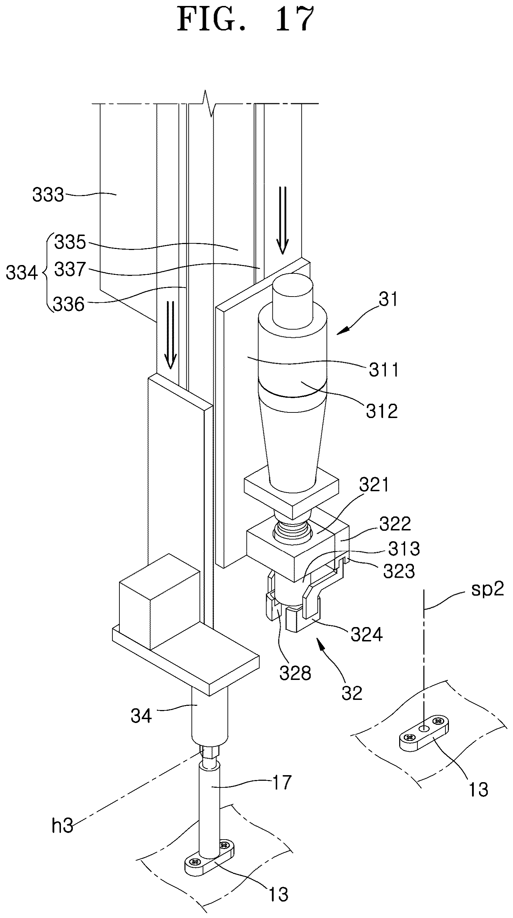

In the first moving operation (S1), as shown in FIG. 14, the detection device 34 may be positioned at the first set position sp1. At this time, the detection device 34 and the gripper device 32 may be positioned at a first height h1. In the first descending operation (S2), as shown in FIG. 16, the detection device 34 is lowered along the first rail 336 to be positioned below the gripper device 32, and as shown in FIG. 17, the third moving body 334 may be lowered while the detection device 34 remains positioned below the gripper device 32.

With the detection device 34 lowered along the first rail 336, the detection device 34 may be positioned at a second height h2. By further lowering the third moving body 334 while keeping the detection device 34 positioned below the gripper device 32 as described herein, the detection device 34 may be lowered to a third height h3. At this time, the detection device 34 may have a descending displacement equal to a sum of a distance by which the third moving body 334 is lowered and a distance by which the detection device 34 is lowered along the first rail 336. The detection device 34 may be lowered from the first height h1 to the third height h3 through the multi-stage descending process as described herein.

By connecting the detection device 34 to the third moving body 334 through the first rail 336 in a manner that allows vertical movement, the guide bar 331 can be positioned at a lower height from the ground compared to an embodiment in which the detection device 34 is integrally fixed and connected to the third moving body 334. This arrangement can reduce the overall vertical (up-down) height of the battery pack assembly unit 1 according to the present disclosure. Accordingly, the process can be easily inspected by a worker with the naked eye, thereby facilitating easier maintenance and management and allowing the impact force acting on the detection device 34 to be absorbed at the connection portion with the first rail 336.

The detection device 34, which has been lowered to the third height h3, may be in contact with the support fixture 17 positioned at the first set position sp1. In the support fixture detection operation (S3), as shown in FIG. 17, the detection device 34 is brought into contact with the support fixture 17 to detect that the support fixture 17 is positioned at the first set position sp1. In the first ascending operation (S4), the detection device 34 may be raised along the first rail 336, and the third moving body 334 may be raised along the second moving body 333 to return to the first height h1. At this time, the movement of the detection device 34 and the movement of the third moving body 334 may be performed sequentially, in reverse order, or simultaneously.

Processes of unfastening the support fixture 17 using the fastening device 31, gripping the support fixture 17 using the gripper device 32, and separating support fixture 17 from the plate 11 may be performed sequentially through a device exchange operation (S5), a second descending operation (S6), an unfastening operation (S7), a clamping operation (S8), and a second ascending operation (S9).

In the device exchange operation (S5), the fastening device 31 and the gripper device 32 may be moved rearward by the set distance d2 to be positioned at the first set position sp1. The device exchange operation (S5) may be performed by moving the second moving body 333 rearward by the set distance d2 along the first moving body 332. When the second moving body 333 is moved rearward by the set distance d2, the fastening device 31, the gripper device 32, and the detection device 34 may be moved rearward together by the set distance d2. In a state in which the device exchange operation (S5) is completed, the gripper device 32 may be positioned at the first height h1.

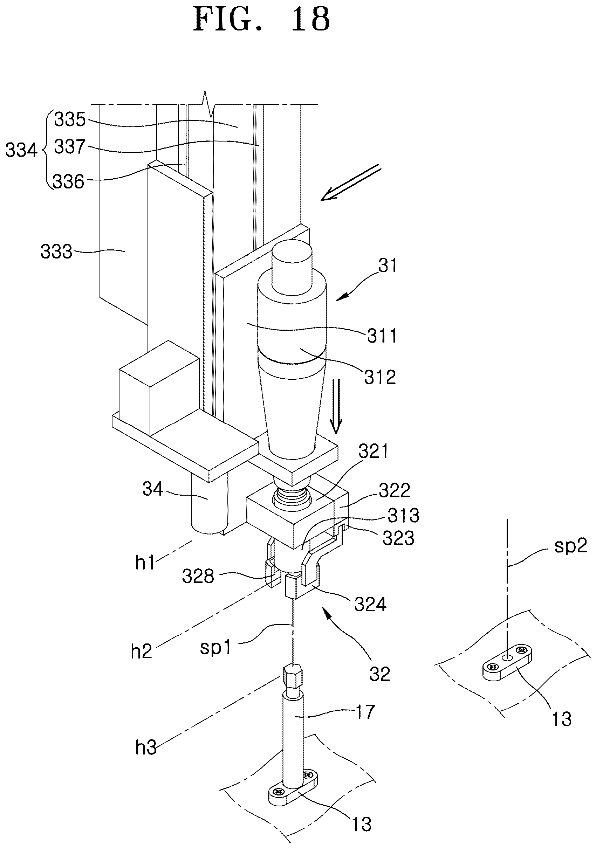

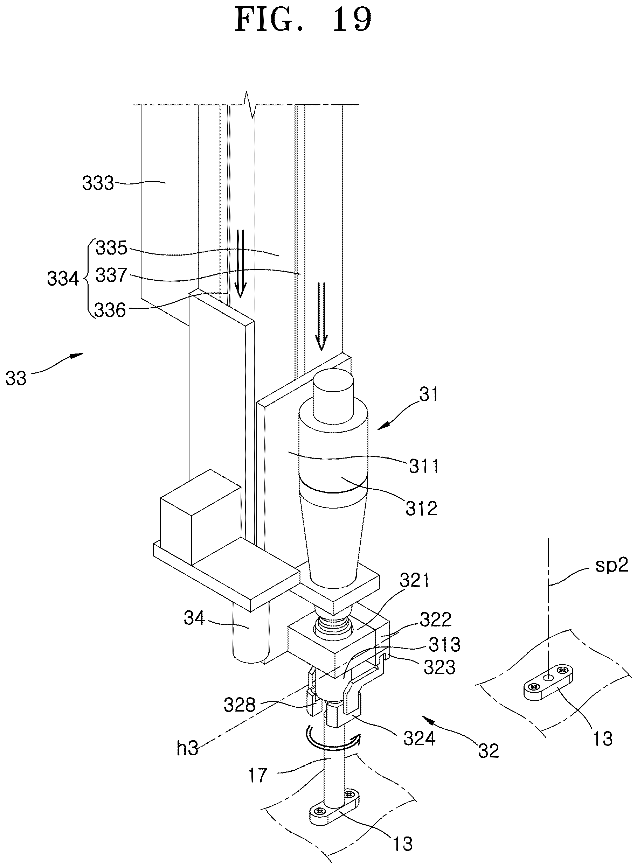

In the second descending operation (S6), as shown in FIG. 18, the fastening device 31 and the gripper device 32 may be lowered along the second rail 337 to be positioned below the detection device 34, and as shown in FIG. 19, the third moving body 334 may be further lowered with the fastening device 31 and the gripper device 32 positioned below the detection device 34.

By lowering the first support 311 along the second rail 337, the fastening device 31 and the gripper device 32 may be lowered along the second rail 337. In the state in which the fastening device 31 and the gripper device 32 are lowered along the second rail 337, the fastening device 31 and the gripper device 32 may be positioned at the second height h2. By further lowering the third moving body 334 with the fastening device 31 and the gripper device 32 positioned below the detection device 34 as described herein, the fastening device 31 and the gripper device 32 may be lowered to the third height h3. At this time, the fastening device 31 and the gripper device 32 may have a descending displacement equal to a sum of a distance by which the fastening device 31 and the gripper device 32 are lowered along the second rail 337 and a distance by which the third moving body 334 is lowered. The fastening device 31 and the gripper device 32 may be lowered from the first height h1 to the third height h3 through the multi-stage descending process as described herein.

By connecting the fastening device 31 and the gripper device 32 to the third moving body 334 through the second rail 337 in a manner that allows vertical movement as described herein, the guide bar 331 can be positioned at a lower height from the ground compared to an embodiment in which the fastening device 31 and the gripper device 32 are integrally fixed and connected to the third moving body 334. This arrangement can reduce the overall vertical (up-down) height of the battery pack assembly unit 1 according to the present disclosure. Accordingly, the process can be easily inspected by the operator with the naked eye, thereby facilitating easier maintenance and management and allowing the impact force acting on the fastening device 31 and the gripper device 32 to be absorbed at the connection portion with the second rail 337.

The fastening device 31, which has been lowered to the third height h3, may be in contact with the support fixture 17 positioned at the first set position sp1. In the unfastening operation (S7), as shown in FIG. 19, the fastening device 31 may be brought into contact with the support fixture 17, and a reverse rotational force may be applied to the support fixture 17 using the fastening device 31 to unfasten the support fixture 17 from the installation base 13 positioned at the first set position sp1. In the clamping operation (S8), the support fixture 17 may be clamped using the gripper device 32.

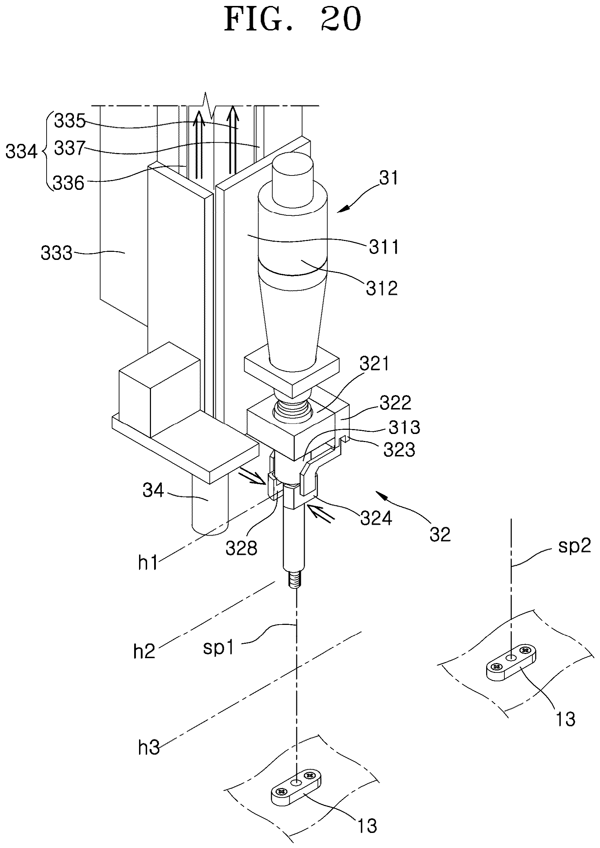

In the second ascending operation (S9), the first support 311 may be raised along the second rail 337, and the third moving body 334 may be raised along the second moving body 333 to return to the first height h1, as shown in FIG. 20. At this time, the movement of the first support 311 and the movement of the third moving body 334 may occur sequentially, in reverse order, or simultaneously.

Processes of moving the support fixture 17 to the second set position sp2 and fastening the support fixture 17 to the plate 11 may be performed sequentially through a second moving operation (S10), a third descending operation (S11), an unclamping operation (S12), and a fastening operation (S13).

In the second moving operation (S10), the support fixture 17 may be moved to the second set position sp2. The second set position sp2 may be positioned on front of the first set position sp1. By moving the second moving body 333 forward along the first moving body 332, the support fixture 17 may be moved from the first set position sp1 to the second set position sp2. When the second moving body 333 is moved forward, the fastening device 31, the gripper device 32, and the detection device 34 may also be moved forward together. In a state in which the second moving operation (S10) is completed, the gripper device 32 may be positioned at the first height h1.

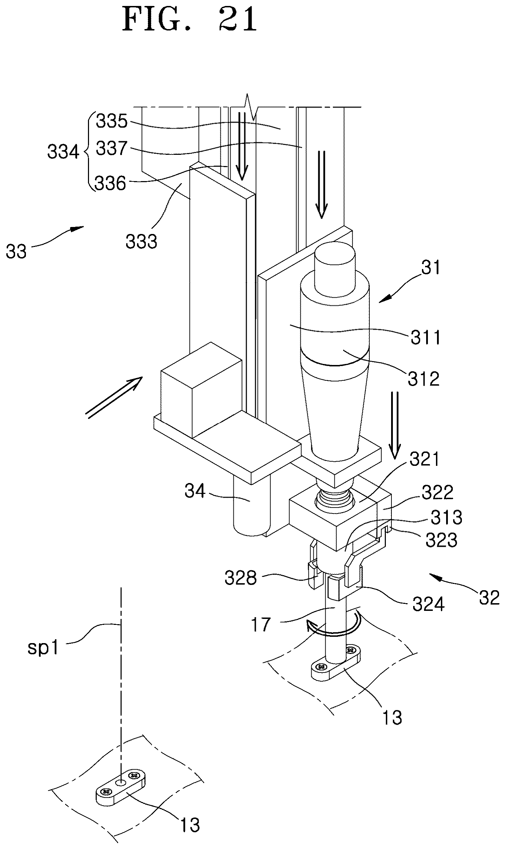

In the third descending operation (S11), the fastening device 31 and the gripper device 32 may be lowered along the second rail 337 to be positioned below the detection device 34, and as shown in FIG. 21, the third moving body 334 may be further lowered with the fastening device 31 and the gripper device 32 positioned below the detection device 34.

By lowering the first support 311 along the second rail 337, the fastening device 31 and the gripper device 32 may be lowered along the second rail 337. When the fastening device 31 and the gripper device 32 are lowered along the second rail 337, the fastening device 31 and the gripper device 32 may be positioned at the second height h2. By further lowering the third moving body 334 with the fastening device 31 and the gripper device 32 positioned below the detection device 34 as described herein, the fastening device 31 and the gripper device 32 may be lowered to the third height h3.

At this time, the fastening device 31 and the gripper device 32 may have a descending displacement equal to a sum of a distance by which the fastening device 31 and the gripper device 32 are lowered along the second rail 337 and a distance by which the third moving body 334 is lowered. The movement of the first support 311 and the movement of the third moving body 334 may occur sequentially, in reverse order, or simultaneously. The fastening device 31 and the gripper device 32 may be lowered from the first height h1 to the third height h3 through the multi-stage descending process as described herein.

When the fastening device 31 and the gripper device 32 are lowered to the third height h3, the support fixture 17 may come into contact with and seated on the installation base 13 positioned at the second set position sp2. In the unclamping operation (S12), the support fixture 17 may be unclamped using the gripper device 32. In the fastening operation (S13), with the support fixture 17 seated on the installation base 13, a forward rotational force may be applied to the support fixture 17 using the fastening device 31 to fasten the support fixture 17 to the installation base 13 positioned at the second set position sp2, as shown in FIG. 21.

By repeatedly performing the herein control process for the plurality of support fixtures 17, the positions of the support fixtures 17 can be varied and adjusted according to the model of the battery pack 2 to be manufactured.

According to an embodiment of the present disclosure, a position of a support fixture installed on a pallet can be automatically adjusted using a support fixture moving device to match a model of a battery pack to be manufactured. Accordingly, battery packs of different models can be manufactured on a single battery pack production line corresponding to an extended path of a transfer conveyor, while further reducing a process defect rate, shortening working time, and preventing safety accidents caused by the dropping of the support fixture during manual operation compared to when an operator manually changes the position of the support fixture.

Further, according to an embodiment of the present disclosure, a support fixture can be fastened to or unfastened from an installation base using a fastening device of a support fixture moving device, the support fixture can be clamped or unclamped using a gripper device, and the fastening device, the gripper device, and the support fixture can be moved to a desired position using a moving device. Accordingly, based on a model of a battery pack to be produced, the support fixture can be automatically removed and assembled at the desired position using the support fixture moving device.

However, the effects obtainable through the present disclosure are not limited to the herein effects, and other technical effects that are not mentioned will be clearly understood by those skilled in the art from the following description of the present disclosure.

While the present disclosure has been described with reference to embodiments shown in the drawings, these embodiments are merely illustrative and it should be understood that various modifications and equivalent other embodiments can be derived by those skilled in the art on the basis of the embodiments.

## Claims

1. A battery pack assembly unit comprising:
a pallet comprising a plate configured to support components of one or more battery packs, and one or more support fixtures configured to constrain the components from moving;
a transfer conveyor configured to transport the pallet; and
a support fixture moving device disposed above the transfer conveyor and configured to change positions of the one or more support fixtures based on a shape and a size of each of the components.

2. The battery pack assembly unit as claimed in claim 1, wherein each of the battery packs comprises a housing configured to be seated on the pallet, and one or more battery cells accommodated in the housing, and
each component comprises the housing.

3. The battery pack assembly unit as claimed in claim 1 or 2, wherein the plate comprises:
a plate body configured to be loaded on the transfer conveyor; and
a plurality of installation bases which are configured to be installed on an upper surface of the plate body, and to which the one or more support fixtures are detachably coupled.

4. The battery pack assembly unit as claimed in claim 3, wherein each of the installation bases comprises:
an installation base body configured to be disposed on the upper surface of the plate body;
a fastening groove formed in the installation base body and having a female screw structure that allows the support fixture to be screwed; and
fixing members disposed on both sides of the fastening groove and configured to fix the installation base body to the plate body.

5. The battery pack assembly unit as claimed in any preceding claim, wherein the pallet comprises:
a first region configured to seat a first component comprised in a first battery pack;
a second region configured to sear a second component comprised in a second battery pack; and
a third region shared by a portion of the first region and a portion of the second region,
and wherein the one or more support fixtures comprise:
one or more first support fixtures disposed in the third region and configured to support the first component; and
one or more second support fixtures configured to support the second component.

6. The battery pack assembly unit as claimed in claim 5, when dependent on claim 3, wherein the installation bases comprise:
one or more first installation bases to which the one or more first support fixtures are detachably fastened, and which are positioned in the first region, at least one first installation base being positionable in the third region;
one or more second installation bases to which the one or more second support fixtures are detachably fastened, and which are positioned in the second region; and
one or more third installation bases to which the one or more first support fixtures are detachably fastened, and which are positioned outside the second region, and
the first support fixtures are fastenable to the first installation bases when the first component is assembled, and are unfastenable from the first installation bases and then fastenable to the third installation bases by the support fixture moving device when the second component is assembled.

7. The battery pack assembly unit as claimed in claim 5 or 6, wherein the first component has a width greater than half a width of the plate and one first component is placed on the pallet,
the second component has a width less than half the width of the plate and a plurality of second components are placed on the pallet,
the one or more first support fixtures are disposed to correspond to edges of the first component, and
the one or more second support fixtures are disposed to correspond to edges of the second component.

8. The battery pack assembly unit as claimed in claim 5, 6 or 7, wherein one or more of the second support fixtures are disposed in the third region, and
each of the second support fixtures disposed in the third region has a shorter length than each of the one or more first support fixtures to prevent interference with the first component when the first component is in contact with the first support fixtures.

9. The battery pack assembly unit as claimed in claim 7 or 8, wherein the installation bases comprise:
a first group formed by arranging a plurality of second installation bases at a first position along one of the edges of at least one of the first component and the second component; and
a second group formed by arranging a plurality of second installation bases at a second position, which is spaced apart from the first position, along one of the edges of at least one of the first component and the second component, and
each second support fixture is fastened to one of the plurality of second installation bases, which form the first group when the second component is assembled and is moved to another one of the plurality of second installation bases, which form the first group, and fastened thereto by the support fixture moving device when a third component comprised in a third battery pack is assembled.

10. The battery pack assembly unit as claimed in any preceding claim, wherein each of the support fixtures comprises:
a support bar disposed to protrude upwardly from the plate;
a fastening portion formed at a lower portion of the support bar, having a male screw structure, and detachably screwed onto the plate; and
a holding portion formed at an upper part of the support bar and configured to engage with the support fixture moving device.

11. The battery pack assembly unit as claimed in claim 10, wherein the holding portion comprises:
a rotation holding portion having a cross-sectional shape other than a circular cross-sectional shape and configured to engage with a fastening device of the support fixture moving device;
a grip holding portion disposed below the rotation holding portion, formed to be recessed along a circumference of each support fixture, and held by a gripper device of the support fixture moving device; and
a locking step which is formed between the rotation holding portion and the grip holding portion, and on which the gripper device of the support fixture moving device is caught.

12. The battery pack assembly unit as claimed in any preceding claim, wherein the support fixture moving device comprises:
a fastening device configured to fasten or unfasten the support fixtures to or from the plate;
a gripper device configured to clamp or unclamp the support fixtures;
a moving device configured to move the support fixture gripped by the gripper device to a first set position or a second set position on the pallet; and
a control device configured to control an operation of each of the fastening device, the gripper device, and the moving device.

13. The battery pack assembly unit as claimed in claim 12, wherein the fastening device comprises:
a first support installed on the moving device;
a first actuator fixed to the first support and configured to output a rotational force; and
a socket connected to the first actuator and configured to engage with each support fixture when the fastening device descends.

14. The battery pack assembly unit as claimed in claim 13, wherein the gripper device comprises:
a second support installed on the moving device;
a second actuator fixed to the second support and configured to output a hydraulic or pneumatic pressure;
a guide block installed on the second support;
a first gripper installed on the guide block; and
a second gripper disposed on the guide block to face the first gripper, with a distance from the first gripper variable by an operation of the second actuator.

15. The battery pack assembly unit as claimed in claim 14, wherein the first gripper comprises:
a block connection portion configured to be installed on the guide block to be reciprocally movable in a direction toward or away from the second gripper;
an extension portion extending downwardly from the block connection portion to a lower side of the socket; and
a gripping finger connected to the extension portion, positioned below the socket to face the support fixture, and having an arcuate shape, which corresponds to a circumference of the support fixture, on one surface facing the support fixture.
